# EUROPEAN PATENT SPECIFICATION

(11) **EP 0 693 626 B1**
(45) Date of publication and mention of the grant of the patent: **09.06.1999**
(21) Application number: 95111456.0
(22) Date of filing: 20.07.1995
(51) Int. Cl.: F04B 37/08, F04D 19/04, C23C 14/56, H01L 21/00

(54) **Vacuum chamber for ultra high vacuum processing at high temperatures**
Vakuumkammer für Ultrahochvakuumbehandlung bei hoher Temperatur
Chambre à vide pour traitement en ultravide à haute température

(30) Priority: 20.07.1994 US 277881
(43) Date of publication of application: 24.01.1996
(73) Proprietor: APPLIED MATERIALS, INC., Santa Clara, California 95054-3299 (US)
(72) Inventor: Ramaswami, Seshadri, Saratoga, CA 95070 (US); Davenport, Robert, San Jose, CA 95120 (US); Nulman, Jaim, Palo Alto, CA 94306 (US)
(74) Representative: DIEHL GLAESER HILTL & PARTNER

(56) References cited:
- FR-A- 2 511 709
- US-A- 3 625 019
- US-A- 4 910 965
- US-A- 5 357 760
- PATENT ABSTRACTS OF JAPAN vol. 010 no. 081 (M-465) ,29 March 1986 & JP-A-60 222572 (NICHIDEN ANELVA KK) 7 November 1985,
- SOLID STATE TECHNOLOGY, JULY 1983, USA, vol. 26, no. 7, ISSN 0038-111X, pages 39-40, 'System grows complex single crystal materials'
- PATENT ABSTRACTS OF JAPAN vol. 007 no. 223 (M-247) ,4 October 1983 & JP-A-58 117372 (NIPPON SHINKU GIJUTSU KK) 12 July 1983,
- PATENT ABSTRACTS OF JAPAN vol. 011 no. 333 (M-637) ,30 October 1987 & JP-A-62 113876 (HITACHI LTD) 25 May 1987,
- PROCEEDINGS OF THE 32ND NATIONAL SYMPOSIUM OF THE AMERICAN VACUUM SOCIETY, HOUSTON, TX, USA, 19-22 NOV. 1985, JOURNAL OF VACUUM SCIENCE & TECHNOLOGY A (VACUUM, SURFACES, AND FILMS), MAY-JUNE 1986, USA, UEDA S ET AL 'A high performance molecular beam epitaxy system equipped with the automatic substrate transport mechanism'

## Description

The present invention relates to vacuum processing equipment. More particularly, the present invention relates to the creation and maintenance of ultra high vacuum environments in which substrates, including semiconductor substrates, may be processed by sputtering or other processes.

Thin film deposition apparatus and techniques are used, among other techniques, to provide film layers on semiconductor substrates. One well known prior art deposition process is sputtering. A sputter deposition apparatus generally comprises a high vacuum chamber which encloses the substrate and a target composed of the material desired to be deposited on the substrate. A negative voltage applied to the target excites into a plasma state an inert gas (typically argon) supplied to the chamber. Ions from the plasma bombard the target and eject particles of target material from the target toward the substrate. These particles deposit on the substrate to form the desired film. In some sputtering process applications the substrate may he heated to temperatures on the order of 450°C to 510°C, to reflow the film layer deposited on the substrate by sputtering.

A combination of a roughing pump and a cryogenic pump is typically used to provide the vacuum in the sputtering chamber. Where the chamber is maintained at a temperature of below approximately 300°C, the roughing pump can reduce the pressure within the chamber to about 10⁻³ torr, and the cryogenic pump can then reduce the chamber pressure to a pressure on the order of 10⁻⁸ torr.

To minimize the inclusion of impurities or contaminants in the film deposited on the substrate, it is generally considered desirable to maintain the sputtering chamber at the highest possible vacuum, that is, the lowest possible pressure. However, the greater the vacuum in the chamber and the higher the temperature in the chamber, the greater the influx of undesirable hydrogen molecules into the chamber due to outgassing of hydrogen molecules from the chamber components.

Since hydrogen is an undesirable impurity in the deposited film, the highest vacuum and highest temperature at which the sputtering chamber can be operated is limited by the ability of the cryogenic pump to remove the hydrogen. Because of the low condensation temperature of hydrogen, cryogenic pumps are relatively ineffective at removing hydrogen. The difficulty of maintaining a sufficiently low partial pressure of hydrogen has limited the ability of existing sputtering chambers to operate at high temperatures and ultra-high vacuums.

Sputter deposition of aluminum films on semiconductor substrates is an application in which ultra-high vacuum at high temperatures is especially desirable. The ultra high vacuum is used to obtain a clean environment in the chamber. The chamber pressure for sputtering, commonly as high as the milli-torr range, is commonly achieved by first evacuating the chamber to an ultra high vacuum pressure as low as the 10 ⁻⁸ torr range to remove contaminants from the chamber, and then re-filling ("back filling") the chamber with a clean process gas at a total chamber pressure regulated at about 10⁻³. torr.

High substrate temperatures are used to enhance the step coverage of the deposited film, that is, to improve the ability of the film to completely fill holes and trenches in the surface of the semiconductor substrate. Higher temperatures promote the diffusion of deposited atoms, called "reflow," to fill any gaps in, and equalize the thickness of, the film as it is being deposited. Lower chamber pressures promote reflow of the deposition material on the substrate by reducing the occurrence of reflow inhibiting contaminants on the substrate surface. Reflow may occur simultaneously with the deposition of the film layer, at the end of the deposition step, or in a separate chamber dedicated to reflow.

For aluminum reflow, the substrate generally is heated by heating the pedestal which holds the substrate during processing. This heating increases the outgassing of hydrogen from the pedestal. The hot pedestal also radiantly heats the chamber walls and other internal components, thereby increasing their hydrogen outgassing rate. Consequently, existing sputter deposition chambers have achieved a chamber pressure of about 1.5 x 10⁻⁸ torr at a substrate temperature of 510°C. At this temperature and pressure, the major gas constituent in the chamber is hydrogen. The limited ability of the cryogenic pump to pump hydrogen, in combination with the outgassing of hydrogen from the chamber components, creates an equilibrium point at this temperature and pressure when a cryogenic pump is used as the high vacuum pump. However, reflow can be achieved at temperatures as high as 650°C, and higher temperatures are beneficial to the reflow rate and quality of the reflow.

Therefore, there is a need to provide higher vacuum levels and/or higher temperatures within the vacuum chamber in order to improve step coverage of the deposited film, reduce the time required for reflow, and/or reduce the impurity concentration in the film. Alternatively, achieving higher vacuum, i.e., lower pressure levels, would allow the use of lower reflow temperatures to achieve a desired reflow of the deposition layer, because fewer reflow inhibiting contaminants will form on the substrate at the lower pressure. By reducing the reflow temperature, the risk of damage to devices formed on the substrate is reduced.

In response to the above need the present invention provides the vacuum processing apparatus according to independent claim 1, and the method according to independent claim 14. Further advantageous features, aspects and details of the invention are evident from the dependent claims, the description and the drawings. The claims are intended to be understood as a first non-limiting approach of defining the invention in general terms.

The present invention employs a cryogenic pump and a getter pump in combination to enable a higher vacuum to be achieved at elevated temperatures within an enclosure, for example within a high vacuum chamber such as a sputtering chamber.

The getter pump removes outgassed hydrogen from the vacuum chamber, thereby enabling the cryogenic pump to reduce the chamber pressure to a lower level (higher vacuum) than the cryogenic pump could achieve alone.
The invention will be more fully understood and further advantages will become apparent when reference is made to the following detailed description of the invention and the following drawing in which
Figure 1 is a perspective view, partially in section, of a representative vacuum chamber of the present invention;
Figure 2 is a partial sectional view of the representative vacuum chamber of the present invention, showing the getter pump in section; and
Figure 3 is a perspective view of an alternative gettering pump plate configuration useful with the present invention.

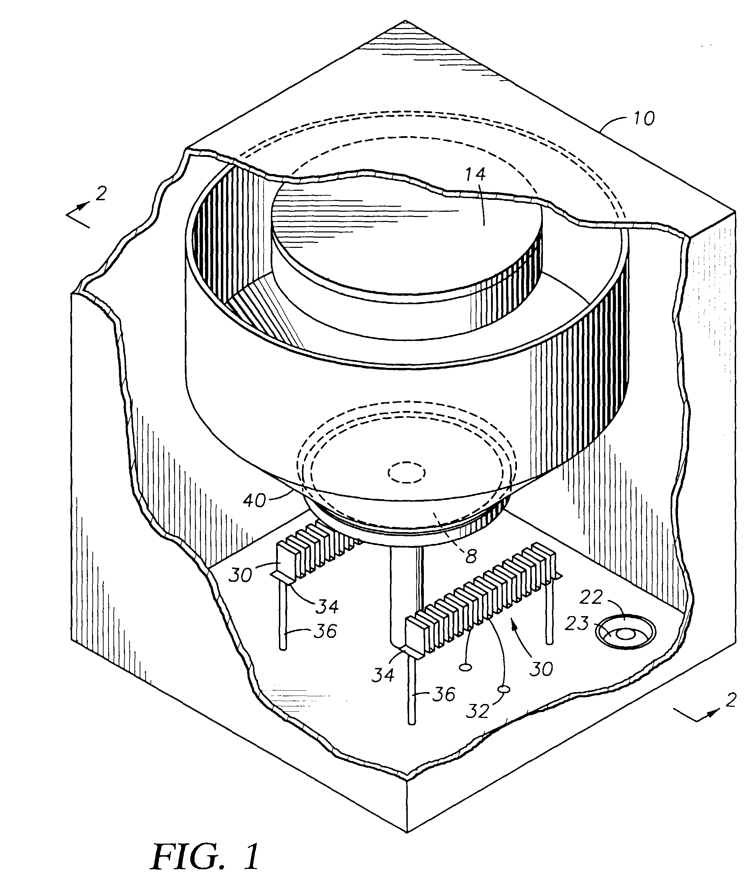

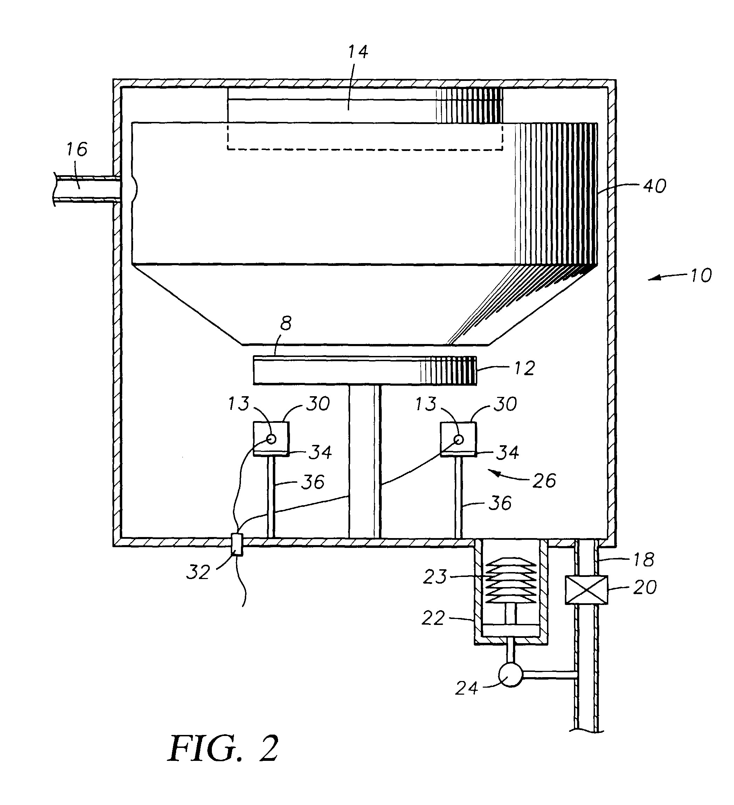

Figures 1 and 2 depict an enclosure such as vacuum chamber 10 for processing a semiconductor substrate 8. The chamber 10 includes a substrate support member or pedestal 12, a sputtering target 14, a gas inlet 16 into which a gas, preferably an inert gas such as argon, is supplied, and an exhaust port 18. The target 14 preferably is a conventional magnetron sputtering target such as that described in United States Patent No. 5,242,566, *Parker*, and the pedestal 12 preferably is internally heated. The pedestal 12 includes a conventional internal heater (not shown) such as that described in United States Patent No. 5,228,501, *Tepman*.

To pump the chamber 10 down to the ultra high vacuum, the chamber 10 includes a roughing pump 20 ported to the chamber exhaust port 18, a cryogenic pump 22 ported to the exhaust port 18 through a valve 24, and a getter pump 26 disposed within the chamber 10 adjacent, and preferably below, the pedestal 12.

The purpose of the roughing pump 20 is to initially reduce the chamber pressure to a level at which a cryogenic pump can operate effectively, typically about 1 x 10⁻³ torr. The cryogenic pump 22 is then engaged to reduce the chamber pressure down to a pressure as low as approximately 7 x 10⁻⁹ torr. The getter pump 26 functions to remove hydrogen and possibly other reactive gases which enter the chamber 10 primarily due to the outgassing of chamber components. The cryogenic pump 22 functions to exhaust the argon process gas from the chamber 10.

In a preferred process for depositing aluminum film on a semiconductor substrate 8 having holes or trenches in its top surface, the pedestal heater is operated to heat the pedestal 12 and the substrate 8 to temperatures as high as 650°C. In prior art sputtering systems, such high temperature could not be achieved together with a chamber pressure as low as 5 to 7 x 10⁻⁹ torr, because at that temperature and pressure the pedestal 12 and perhaps other chamber components would outgas hydrogen at a rate faster than a conventional cryogenic pump 22 could remove it.

In contrast, using our invention, the getter pump 26 removes sufficient hydrogen by chemisorbtion to allow the combination of the cryogenic pump 22 and getter pump 26 to maintain the chamber pressure at about 5 to 7 x 10⁻⁹ torr. The present invention allows the substrate 8 to be maintained at a higher temperature, thereby improving step coverage of the deposited film and/or reducing the time which must be allotted for the film to reflow. Such high temperature can be achieved simultaneously with ultra-high vacuum so as to minimize impurities in the deposited film.

The roughing pump 20 and cryogenic pump 22 are of conventional construction. The roughing pump 20 can be a conventional mechanical pump, although other pumps capable of reducing the chamber pressure into the range of 1 x 10⁻³ torr also would be suitable.

The cryogenic pump 22 preferably includes a conventional condenser array 23 having multiple chevrons through which liquid helium is flown. Gases impinging on the chevrons will condense and flow downwardly on the condenser array to be collected in an exhaust chamber/valve. One such configuration of multiple chevrons in a cryogenic pump is shown in detail in United States Patent Number 4,873,833, *Pfeiffer, et al*. which is fully incorporated hereby reference.

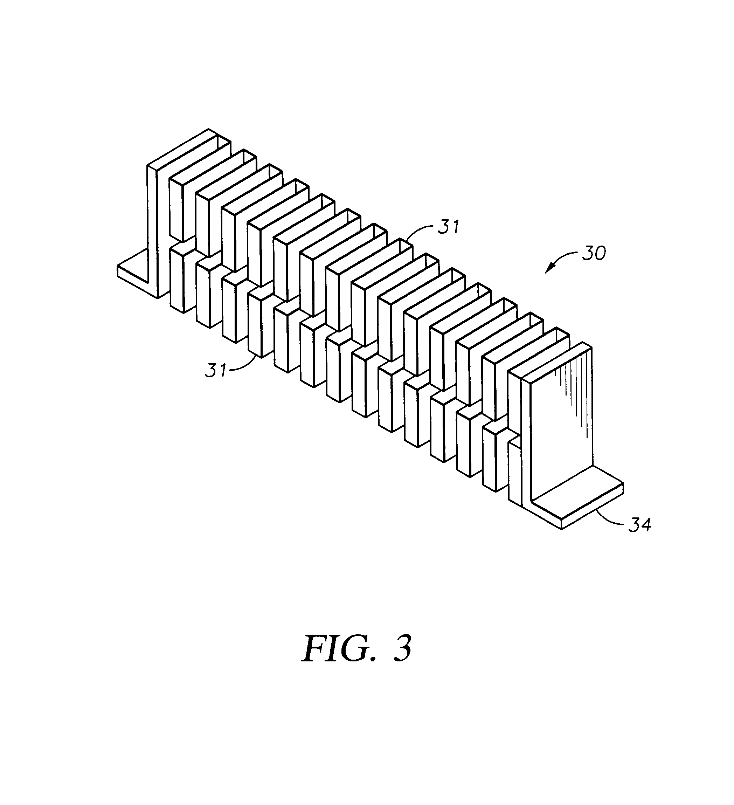

Although the invention could be implemented with a conventional getter pump, Figures 1 and 2 show the details of construction of the preferred getter pump 26. The getter pump 26 preferably is constructed as a pair of rectangular plates 30 of getter material, although the plates 30 may be formed of a non-gettering base material having the gettering material plated or otherwise affixed thereto. Each of the plates 30 is preferably folded into a pleated profile as shown in Figure 1. Although each of the plates 30 is shown as including one pleated member, multiple pleated members 31 may be stacked to form each of the gettering plates 30 as shown in Figure 3. Each of the plates 30 terminates, at either end thereof, in a support flange 34, and a rod 36 extends from the chamber base and connects to the support flange 34 to support the plate 30 above the chamber base. An electrical feedthrough 32 extends through the chamber base to provide power to an internal electric resistance heater 13 (shown in Figure 2) maintained within each of the plates 30.

When a reactive gas species such as hydrogen contacts either of the plates 30, it is sorbed (i.e., gettered) preferably chemisorbed into the plate 30. Thus, as reactive gas species diffuse or migrate within the chamber 10 at the ultra-low chamber pressure, for example at a pressure of less than 1.5 x 10⁻⁸ torr, they are chemisorbed upon contact with the plates. The surface area of the gettering material of the plates 30 is sized large enough to provide chemisorption of the outgassing hydrogen sufficient to maintain the lower chamber pressure of 5 to 7 x 10⁻⁹ torr. However, non-reactive species, such as argon which is commonly used as the process gas, is not absorbed into the getter material.

The getter plates 30 are preferably mounted directly underneath the substrate pedestal 12 as shown in Figures 1 and 2 so that the pedestal 12 acts as a shield between the substrate 8 and the gettering plates 30. Thus, if any particles should be dislodged from the gettering plates 30, such particles will be highly unlikely to lodge on, and thereby contaminate, the substrate 8. The gettering plates may be placed elsewhere in the chamber so long as the uppermost surface of the plates 30 is located below the upper surface of the substrate 8, where the substrate is positioned on the support member as shown in Figures 1 and 2. Additionally, electrically grounded shields 40 may be placed surrounding the region between the target 14 and the substrate support pedestal 12 to confine the plasma to a region above the substrate 8 so as to prevent sputtering of the gettering plates 30 which are positioned below the substrate. However, the plates 30 are also positioned as high as possible underneath the substrate 8 so as to minimize the distance between the plates 30 and the substrate 8, and thereby maximize chemisorbtion of reactive species near the surface of the substrate 8. The region near the substrate surface 8 is where it is most crucial to minimize the concentration of impurities such as hydrogen to prevent these impurities from being incorporated in the film deposited on the substrate.

The getter pump 26 operates by sorbing preferably chemisorbing chemically active species such as hydrogen, but it has virtually no effect on inert gases such as the argon used as the principal process gas for sputtering. Therefore, the gettering pump 26 may be used to retrofit existing chambers 10, without the need to reconfigure or recalibrate the gas flows in the chamber 10.

The preferred plate 30 material is a non-evaporable gettering material that may be reactivated by exposure to high temperatures after multiple process cycles in the chamber. One preferred gettering material is a Zirconium Aluminum material, sold by Saes Getters S.p.A., of Milan, Italy under the designation SORB-AC st101. An additional gettering material that may he used in the chamber is also sold by Saes Getters S.p.A., under the designation st707, which is a Zirconium Vanadium Iron alloy. The st101 material is preferred because it has negligible iron content.

Over time, the chemisorption rate of the getter pump 26 may decline as a result of the cumulative quantity of reactive species that are chemisorbed into the plates 30. At this point, the gettering material forming, or located over, the plates 30 must be reactivated by heating the plates 30 to a temperature on the order of 600 to 750°C, for time periods ranging from 10 to 1000 minutes, to desorb, or drive out, the hydrogen and other gases absorbed by the plates 30. In the preferred embodiment, this heat is supplied by the electric resistance heater 13 disposed within each plate 30. The time required for desorption is inversely proportional to the temperature of desorption and may be optimized for the particular chamber 10 and getter plate 32 configuration. It is believed that the gettering plates may be desorbed up to five times, before they must be replaced.

The high vacuum enabled by the present invention provides benefit to both sputtering and reflow processes. Where sputtering is performed in the chamber, the lower base pressure obtainable in the chamber before backfilling with the process gas yields a cleaner chamber environment. Where the chamber is configured for reflow, the lower pressures enhance reflow by reducing the incidence of particle or chemical contamination of the film layer. Therefore, it is specifically contemplated that the gettering pump 30 may be used for sputtering chambers, sputtering chambers wherein reflow occurs during and/or after sputtering, or dedicated reflow chambers.

Although the present invention has been described herein primarily with respect to a high temperature sputtering chamber, the improved hydrogen pumping and the higher temperature ultra high vacuum conditions made possible by the present invention may be used with other equipment or processes where ultra high vacuums and/or high temperatures are desired.

## Claims

1. A vacuum processing apparatus, comprising
an enclosure (10);
a support member (12) for holding a semiconductor substrate (8) within the enclosure (10);
a heater for raising the temperature of the substrate (8) to a temperature high enough to cause reflow of a layer of material on the substrate (8);
a cryogenic pump (22) being capable of evacuating said enclosure (10) to a first vacuum pressure; and
a getter pump (26) arranged within said enclosure (10) and capable of reducing the pressure in said enclosure from said first pressure to a second lower pressure by sorbing, preferably chemisorbing reactive gas species in the enclosure (10).

2. The vacuum processing apparatus according to claim 1, wherein said cryogenic pump (22) is ported to said enclosure (10).

3. The apparatus of claim 1 or 2, wherein the apparatus is a reflow chamber.

4. The apparatus of claim 1 or 2, wherein the apparatus is a sputtering chamber.

5. The apparatus of one of the preceding claims, wherein said second pressure is in the range of 5 to 7 x 10⁻⁹ torr.

6. The apparatus of any of the preceding claims, wherein said layer of material contains aluminum, and the reflow temperature exceeds 510°C.

7. The apparatus of one of the preceding claims, wherein said getter pump (26) includes a plurality of plates (30) formed of a gettering material.

8. The apparatus of one of claims 4 to 7, wherein said sputtering chamber further includes a sputtering target (14) and a substrate support member (12), said substrate support member (12) including a substrate support surface disposed adjacent said target (14) to receive a substrate (8) thereon; and
said substrate support member (12) is disposed intermediate said gettering pump (26) and said substrate support surface.

9. The apparatus of claim 7 or 8, wherein said gettering material is non-evaporable.

10. The apparatus of one of the preceding claims, further including a roughing pump (20) to produce a pressure in the enclosure (10) higher than the first pressure.

11. The apparatus of one of the preceding claims, wherein the cryogenic pump (22) is disposed in communication with said enclosure (10) and capable of evacuating said enclosure (10) to a chamber pressure of at least 1.5 x 10⁻⁸ torr at a substrate reflow temperature.

12. The apparatus of any of the preceding claims, wherein said heater heats said substrate (8) to a temperature in excess of 510°C and said film layer is aluminum.

13. The apparatus of any of the preceding claims, wherein said enclosure (10) is maintained at pressures below 7 x 10⁻⁹ torr and the substrate (8) is maintained at temperatures above 510°C.

14. A method of providing a vacuum in a processing environment comprising the steps of:
providing a sealable enclosure;
providing a substrate support member in the enclosure;
pumping the enclosure to a first vacuum pressure with a cryogenic pump;
raising the temperature of the support member to a contact reflow temperature; and
pumping the enclosure to a second, lower, pressure with a getter pump located within the enclosure so as to reduce the pressure to the second pressure by sorbing, preferably chemisorbing reactive gas species.

15. The method of claim 14, wherein the second pressure is in the range of 5 to 7 x 10⁻⁹ torr.

16. The method of one of claims 14 to 15, wherein the reflow temperature of the substrate exceeds 510°C.

17. The method of one of claims 14 to 16, further including the step of locating the substrate support member intermediate the substrate and gettering pump.

18. The method of one of claims 14 to 17, wherein the pressure in the enclosure is maintained at a pressure no greater than 7 x 10⁻⁹ torr as the temperature of the substrate support member changes from an ambient temperature to a contact reflow temperature.

19. The method of one of claims 14 to 18, including the additional step of first pumping the chamber to a pressure, higher than the first pressure, with a roughing pump.

## Patentansprüche

1. Vakuumverarbeitungsvorrichtung mit
einem Gehäuse (10);
einem Stützelement (12) zum Halten eines Halbleitersubstrates (8) innerhalb des Gehäuses (10);
einem Heizgerät zur Erhöhung der Temperatur des Substrats (8) auf eine ausreichend hohe Temperatur zur Bewirkung von Rückfluß einer Materialschicht auf dem Substrat (8);
einer Kryopumpe (22), die fähig ist, das Gehäuse (10) auf einen ersten Vakuumdruck zu evakuieren; und
einer Getterpumpe (26), die innerhalb des Gehäuses (10) angeordnet ist und dazu fähig ist, den Druck in dem Gehäuse von dem ersten Druck auf einen zweiten, geringeren Druck durch Sorbieren, vorzugsweise Chemosorbieren von reaktiven Gasarten in dem Gehäuse (10) zu reduzieren.

2. Vakuumverarbeitungsvorrichtung gemäß Anspruch 1, bei der die Kryopumpe (22) durch einen Durchlaß mit dem Gehäuse (10) verbunden ist.

3. Vorrichtung gemäß Anspruch 1 oder 2, wobei die Vorrichtung eine Rückflußkammer ist.

4. Vorrichtung gemäß Anspruch 1 oder 2, bei dem die Vorrichtung eine Sputterkammer ist.

5. Vorrichtung gemäß einem der vorhergehenden Ansprüche, bei der der zweite Druck im Bereich von 5 bis 7 x 10⁻⁹ Torr liegt.

6. Vorrichtung gemäß einem der vorhergehenden Ansprüche, bei der die Materialschicht Aluminium enthält und die Rückflußtemperatur 510°C übersteigt.

7. Vorrichtung gemäß einem der vorhergehenden Ansprüche, bei der die Getterpumpe (26) eine Mehrzahl von Platten (30) aus einem Gettermaterial aufweist.

8. Vorrichtung gemäß einem der Ansprüche 4 bis 7, bei der die Sputterkammer des weiteren ein Sputtertarget (14) und ein Substratstützelement (12) aufweist, wobei das Substratstützelement (12) eine Substratstützfläche benachbart zum Target (14) zur Aufnahme eines Substrates (8) hierauf aufweist; und
das Substratstützelement (12) zwischen der Getterpumpe (26) und der Substratstützfläche angeordnet ist.

9. Vorrichtung gemäß Anspruch 7 oder 8, bei der das Gettermaterial nicht verdampfbar ist.

10. Vorrichtung gemäß einem der vorhergehenden Ansprüche, die des weiteren eine Grobpumpe (20) aufweist, um einen Druck in dem Gehäuse (10) zu erzeugen, welcher höher als der erste Druck ist.

11. Vorrichtung gemäß einem der vorhergehenden Ansprüche, bei der die Kryopumpe (22) in Verbindung mit dem Gehäuse (10) angeordnet ist und fähig ist, das Gehäuse (10) auf einem Kammerdruck von mindestens 1,5 x 10⁻⁸ Torr bei einer Substratrückflußtemperatur zu evakuieren.

12. Vorrichtung gemäß einem der vorhergehenden Ansprüche, bei der das Heizgerät das Substrat (8) auf eine Temperatur über 510°C erwärmt und die Filmschicht Aluminium ist.

13. Vorrichtung gemäß einem der vorhergehenden Ansprüche, bei der das Gehäuse (10) bei Drücken unter 7 x 10⁻⁹ Torr gehalten ist und das Substrat (8) bei Temperaturen über 510°C gehalten ist.

14. Verfahren zur Bereitstellung eines Vakuums in einer Verarbeitungsumgebung mit folgenden Schritten:
Bereitstellung eines abdichtbaren Gehäuses;
Bereitstellung eines Substratstützelements in dem Gehäuse;
Pumpen des Gehäuses auf einen ersten Vakuumdruck mit einer Kryopumpe;
Erhöhen der Temperatur des Stützelements auf eine Kontaktrückflußtemperatur; und
Pumpen des Gehäuses auf einen zweiten, niedrigeren Druck mit einer Getterpumpe innerhalb des Gehäuses, um den Druck auf den zweiten Druck durch Sorbieren, vorzugsweise Chemosorbieren von reaktiven Gasarten zu reduzieren.

15. Verfahren gemäß Anspruch 14, bei dem der zweite Druck im Bereich von 5 bis 7 x 10⁻⁹ Torr liegt.

16. Verfahren gemäß Ansprüchen 14 bis 15, bei dem die Rückflußtemperatur des Substrats 510°C übersteigt.

17. Verfahren gemäß einem der Ansprüche 14 bis 16, mit des weiteren der Anordnung des Substratstützelements zwischen dem Substrat und der Getterpumpe.

18. Verfahren gemäß einem der Ansprüche 14 bis 17, bei dem der Druck in dem Gehäuse auf einem Druck von nicht mehr als 7 x 10⁻⁹ Torr bei Änderung der Temperatur des Substratstützelements von einer Umgebungstemperatur auf eine Kontaktrückflußtemperatur gehalten wird.

19. Verfahren gemäß einem der Ansprüche 14 bis 18, mit dem zusätzlichen Schritt des zunächst Pumpens der Kammer auf einen Druck, welcher höher als der erste Druck ist, mit einer Grobpumpe.

## Revendications

1. Appareil de traitement sous vide, comprenant :
une enceinte (10) ;
un élément support (12) pour tenir un substrat semi-conducteur (8) dans l'enceinte (10) ;
un dispositif de chauffage pour élever la température du substrat (8) à une température suffisante pour provoquer un reflux d'une couche de matériau sur le substrat (8) ;
une pompe cryogénique (22) capable d'abaisser la pression dans ladite enceinte (10) jusqu'à une première pression réduite ; et
une pompe de dégazage (26) disposée dans ladite enceinte (10) et capable de réduire la pression dans ladite enceinte depuis ladite première pression jusqu'à une seconde pression inférieure par sorption, de préférence chimisorption, de composés gazeux réactifs présents dans ladite enceinte (10).

2. Appareil de traitement sous vide selon la revendication 1, dans lequel ladite pompe cryogénique (22) débouche dans ladite enceinte (10).

3. Appareil selon la revendication 1 ou 2, qui est une chambre de reflux.

4. Appareil selon la revendication 1 ou 2, qui est une chambre de pulvérisation cathodique.

5. Appareil selon l'une des revendications précédentes, dans lequel ladite seconde pression est comprise dans la gamme allant de 5 à 7 x 10⁻⁹ torr.

6. Appareil selon l'une quelconque des revendications précédentes, dans lequel ladite couche de matériau contient de l'aluminium, et la température de reflux excède 510°C.

7. Appareil selon l'une des revendications précédentes, dans lequel ladite pompe de dégazage (26) comprend une série de plateaux (30) formés d'un matériau de dégazage.

8. Appareil selon l'une des revendications 4 à 7, dans lequel ladite chambre de pulvérisation cathodique comprend en outre une cible de pulvérisation cathodique (14) et un élément (12) formant support de substrat, ledit élément (12) formant support de substrat comprenant une surface de support de substrat disposée adjacente à ladite cible (14) pour y recevoir un substrat (8) ; et
ledit élément (12) formant support de substrat est disposé entre ladite pompe de dégazage (26) et ladite surface de support de substrat.

9. Appareil selon la revendication 7 ou 8, dans lequel ledit matériau de dégazage n'est pas évaporable.

10. Appareil selon l'une des revendications précédentes, comprenant en outre une pompe à dégrossir (20) pour produire une pression dans l'enceinte (10) supérieure à ladite première pression.

11. Appareil selon l'une des revendications précédentes, dans lequel ladite pompe cryogénique (22) est disposée en communication avec ladite enceinte (10) et capable de réduire la pression régnant dans ladite enceinte (10) jusqu'à une pression de chambre d'au moins 1,5 x 10⁻⁸ torr à une température de reflux du substrat.

12. Appareil selon l'une quelconque des revendications précédentes, dans lequel ledit dispositif de chauffage chauffe ledit substrat (8) à une température supérieure à 510°C et dans lequel ladite couche pelliculaire est l'aluminium.

13. Appareil selon l'une des revendications précédentes, dans lequel ladite enceinte (10) est maintenue à des pressions inférieures à 7 x 10⁻⁹ torr et le substrat (8) est maintenu à des températures supérieures à 510°C.

14. Procédé de création d'un vide dans un environnement de traitement comprenant les étapes suivantes :
La prévision d'une enceinte pouvant être fermée hermétiquement ;
la prévision d'un élément formant support de substrat dans l'enceinte ;
le pompage de ladite enceinte jusqu'à une première pression réduite au moyen d'une pompe cryogénique ;
l'élévation de la température de l'élément support jusqu'à une température de reflux par contact ; et
le pompage de l'enceinte jusqu'à une seconde pression inférieure au moyen d'une pompe de dégazage située dans l'enceinte de façon à réduire la pression jusqu'à la seconde pression par sorption, de préférence chimisorption, de composants gazeux réactifs.

15. Procédé selon la revendication 14, dans lequel la seconde pression est comprise dans la gamme allant de 5 à 7 x 10⁻⁹ torr.

16. Procédé selon l'une des revendications 14 à 15, dans laquelle la température de reflux du substrat excède 510°C.

17. Procédé selon l'une des revendications 14 à 16, comprenant en outre l'étape de mise en place de l'élément formant support de substrat entre le substrat et la pompe de dégazage.

18. Procédé selon l'une des revendications 14 à 17, dans lequel la pression dans l'enceinte est maintenue à une valeur n'excédant pas 7 x 10⁻⁹ torr tandis que la température de l'élément formant support de substrat change depuis la température ambiante jusqu'à une température de reflux par contact.

19. Procédé selon l'une des revendications 14 à 18, comprenant l'étape supplémentaire de pompage, dans un premier temps, de la chambre à une pression supérieure à la première pression au moyen d'une pompe à dégrossir.
